Europäisches Patentamt

European Patent Office

Office européen des brevets

(19)

(11) Numéro de publication : **0 504 024 A1**

(12) **DEMANDE DE BREVET EUROPEEN**

(21) Numéro de dépôt : **92400590.3**

(22) Date de dépôt : **06.03.92**

(51) Int. Cl.⁵ : **H03H 17/02,** G01S 5/14

(30) Priorité : **15.03.91 FR 9103187**

(43) Date de publication de la demande :
**16.09.92 Bulletin 92/38**

(84) Etats contractants désignés :
**DE GB IT**

(71) Demandeur : **THOMSON-CSF**
**51, Esplanade du Général de Gaulle**
**F-92800 Puteaux (FR)**

(72) Inventeur : **Marcuard, Alain**
**THOMSON-CSF, SCPI, Cédex 67**
**F-92045 Paris la Défense (FR)**

(74) Mandataire : **Lincot, Georges et al**
**THOMSON-CSF SCPI**
**F-92045 PARIS LA DEFENSE CEDEX 67 (FR)**

(54) Calculateur de navigation multisenseurs à filtre de Kalman modulaire.

(57)    Le calculateur comporte un nombre déterminé de modules de filtrage primaires (6) et
secondaires (7) interposés respectivement
entre des senseurs (8, 9) et une base de filtrage
de Kalman commune (10).
    Les modules de filtrage primaire (6) et secon-
daire (7) sont définis pour appliquer à la base de
filtrage (10) des vecteurs de mesure préfiltrés
dans un format identique au vecteur d'état de la
base de filtrage (10).
    Application : Calculateur de navigation par
satellite

FIG.2

EP 0 504 024 A1

La présente invention concerne un calculateur de navigation multisenseurs à filtre de Kalman modulaire.

Elle s'applique notamment à la réalisation de calculateurs de navigation couplés à des senseurs très divers tels que des récepteurs GPS code CA économiques du type de ceux décrits par exemple dans les publications de l'institut de navigation de Washington DC ayant pour titre "Global positioning system" n° 0.936406-01.1 et n° 0.936406-00.3, mais encore des compas magnétiques, des détecteurs de tangage, des podomètres ou de façon générale à des senseurs non modélisables à partir d'équations linéaires.

Il est connu que les filtres de Kalman résolvent de façon élégante les problèmes rencontrés dans la technique du filtrage linéaire. Ceux-ci ont en effet les particularités de pouvoir être décrits par des équations différentielles récurrentes se prêtant bien aux techniques de résolution sur calculateurs numériques, et de pouvoir fournir, lorsqu'ils sont utilisés pour résoudre des problèmes de navigation, non seulement une estimée optimale de la trajectoire géographique linéarisée du mobile sur lequel le calculateur est embarqué mais aussi la variance des erreurs d'estimation. L'adaptation du filtrage de Kalman à la résolution de problèmes non linéaires repose habituellement sur une linéarisation des équations valable sur un domaine limité ; mais ne permet pas une approche beaucoup plus générale, où la non linéarité est prise en compte en dehors du filtrage de Kalman proprement dit.

Dans son principe, un filtre de Kalman a la particularité d'entretenir un modèle de processus observé et de confronter les mesures appliquées à son entrée avec ce qu'elles devraient être pour que l'état du filtre corresponde bien à celui du modèle. L'écart est, d'une part, pris en compte dans la correction d'état, et d'autre part, mémorisé dans la variable de gain du filtre. Dans un tel filtre, il est courant de désigner par "propagation" la phase d'entretien du modèle de processus sur une base temporelle et par "intégration des mesures à un instant k+1" la phase où le modèle propagé à l'instant k+1 est confronté aux mesures. Appliquée à des mobiles, la "propagation" représente l'évolution du mobile et donc sa trajectoire. Cependant comme les filtres de Kalman sont avant tout destinés à la résolution de problèmes dits "Markoviens", la finesse de la résolution de problèmes de navigation est de ce fait très dépendante du facteur de confiance que ceux-ci peuvent apporter à la covariance des bruits de mesure par rapport à la covariance du bruit d'état du processus modélisé, c'est-à-dire dépendante du gain de filtre.

Il est en effet important de noter que la covariance du bruit de mesure est le résultat de l'estimation de l'erreur commise sur la mesure par un dispositif d'observation externe au filtre et que le filtre ne calcule pas la variance des mesures qui lui sont confiées. Egalement, si la covariance du bruit de modèle est le résultat de l'estimation de l'exactitude supposée du modèle du filtre, cette covariance est estimée à priori par le concepteur du modèle. Ainsi, ces deux covariances sont des paramètres d'entrée plus ou moins constants du filtre, dont les observations sont les variables d'entrée.

Par symétrie, la sortie du filtre est constituée par un vecteur d'état, et par une matrice de covariance associée. Cependant le filtre ne calcule pas la covariance de l'estimée du vecteur d'état directement, mais estime la covariance de ce vecteur d'état en fonction des deux covariances d'entrée, par le biais du gain du filtre. Cet estimé de covariance peut ne plus représenter la covariance du vecteur d'état si l'une ou l'autre des variances d'entrée est inexacte.

Un cas remarquable apparaît si les covariances d'entrée sont inexactes dans un rapport inverse, il est alors facile de montrer que le comportement du filtre sera quand même optimal et que le vecteur d'état sera bien estimé ; mais par contre le filtre se trompera sur la valeur de covariance du vecteur d'état.

En ce qui concerne l'estimation du vecteur d'état et du gain du filtre, la covariance de bruit de mesure et la covariance de bruit de modèle jouent des rôles exactement antagonistes.

Ainsi, si le bruit de mesure est pris élevé et/ou le bruit de modèle est pris faible, le gain du filtre sera faible, et les mesures corrigeront peu le modèle supposé très bien connu : le filtre sera alors lent, avec du traînage et de l'erreur statique qui pourront aller jusqu'au décrochage. Ce cas peut être considéré comme un "premier cas suboptimal".

Inversement, si le bruit de mesure est pris faible et/ou le bruit de modèle est pris élevé, le gain du filtre sera élevé, et le filtre accordera une confiance excessive aux mesures : le filtre sera alors rapide, mais très bruité ; si les deux conditions apparaissent simultanément, le filtre pourra même atteindre des conditions d'oscillations de relaxation. Ce deuxième cas peut être considéré comme un " deuxième cas suboptimal".

Le filtre est optimal dans l'extremum situé entre le premier et le deuxième cas, c'est-à-dire évidemment lorsque les covariances des bruits de mesure et de modèle seront correctement estimés. On peut ainsi définir un critère d'optimalité qui n'est pas global, mais relatif au traitement d'un senseur particulier. De la sorte un filtre peut être considéré comme globalement optimal s'il est optimal pour tous les senseurs qu'il traite.

Enfin, c'est seulement pour des valeurs réalistes des paramètres de covariance des bruits de mesure et de bruits d'état du processus modélisé que le filtre pourra être optimal en offrant l'erreur statique la plus faible avec un bruit d'état minimum.

Dans les filtres utilisés en navigation, il n'est pas rare de constater que les mesures issues de certains senseurs propagent directement le modèle, c'est-à-dire sont intégrées en même temps que le vecteur d'état, au lieu de figurer explicitement comme mesures (avec une valeur de covariance associée) dans une mécanisation de Kalman classique.

Il est facile de montrer que cet artifice équivaut à injecter dans le filtre de Kalman des observations associées à une covariance de mesure nulle. Ceci correspond typiquement au deuxième cas suboptical car quel que soit le traitement apporté aux autres senseurs, ces senseurs directement propagés ne sont pas traités de manière optimale. A fortiori, le filtre ne pourra pas être globalement optimal. Inversement, il est évident que le traitement optimal de ces senseurs nécessite de les injecter comme observations avec des covariances représentatives d'erreurs réalistes.

La propagation directe de senseurs dans le modèle d'un filtre de Kalman est donc une erreur qu'il faut absolument éviter.

Le but de l'invention est de pallier les inconvénients précités, c'est-à-dire l'impossibilité de traiter directement des senseurs non linéaires et l'utilisation pernicieuse de senseurs dans le modèle du filtre.

A cet effet, l'invention a pour objet, un calculateur de navigation multisenseurs à filtre de Kalman modulaire embarqué sur un mobile comportant un nombre déterminé de modules de filtrage primaires et secondaires interposés respectivement entre des senseurs et une base de filtrage de Kalman commune caractérisé en ce que la base de filtrage de Kalman commune comporte un propagateur d'état couplé à un moniteur d'intégration des mesures et en ce que les modules de filtrage primaire et secondaire appliquent des vecteurs de mesures préfiltrés à la base de filtrage dans un format identique au vecteur d'état de la base de filtrage.

D'autres caractéristiques et avantages de l'invention apparaîtront ci-après à l'aide de la description qui suit faite en regard des dessins annexés :

– la figure 1 un mode d'organisation d'un filtre de Kalman selon l'invention.
– la figure 2 l'adaptation du mode d'organisation de la figure 1 à la réalisation d'un calculateur de navigation dont un senseur primaire est constitué d'un récepteur GPS.

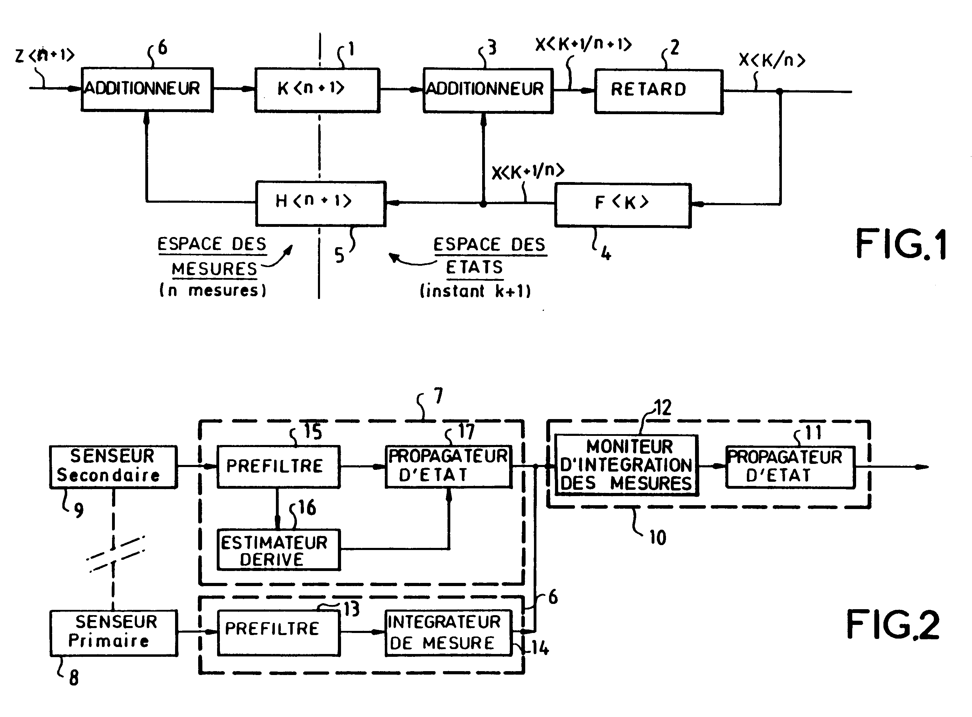

Dans son principe le filtre de Kalman échantillonné utilisé pour la mise en oeuvre de l'invention comporte, de la façon représentée à la figure 1, un amplificateur échantillonné à gain variable 1 couplé à un dispositif à retard 2 par l'intermédiaire d'un circuit additionneur 3. La sortie du circuit à retard 2 est rebouclée sur l'entrée de l'amplificateur à gain variable 1 par l'intermédiaire d'une boucle de contre-réaction formée de deux opérateurs matriciels 4 et 5, la sortie de l'opérateur 5 étant couplée à l'entrée d'un amplificateur 1 par l'intermédiaire d'un circuit additionneur 6. Le circuit additionneur 6 comporte deux entrées, une première entrée qui est reliée à la sortie de l'opérateur matriciel 5 et une deuxième entrée sur laquelle est appliqué un vecteur d'observation ou de mesure $Z(n)$.

En utilisant la notation générale $X<k/n>$ pour désigner la valeur du vecteur d'état du filtre à un instant k connaissant n mesures passées, la description qui suit décrit successivement l'étape de propagation de $x<k/n>$ vers $x<k+1/n>$ puis l'étape d'intégration d'une seule (n+1)e mesure transformant $x<k+1/n>$ en $x<k+1/n+1>$, étant bien entendu qu'au temps t+1 un nombre quelconque de mesures peut être successivement traité.

En désignant respectivement dans ce qui suit par :
– * le produit ligne-colonne des matrices
– $K<k+1>$ le gain de l'amplificateur 1 à un instant courant quelconque noté k + 1
– $F(k)$ la matrice de transfert de l'opérateur matriciel 4 à l'instant k encore appelée ci-après matrice de transition du processus modélisé à l'instant k,
– $Q(k)$ la covariance du bruit d'état du processus modélisé à l'instant k précédant l'instant courant k+1
– $Z(k)$ le vecteur d'observation ou de mesure effectuée à l'instant k,
– $H(n)$ la matrice de l'opérateur 5 encore désignée ci-après par matrice d'observation du système pour la $n^{ième}$ mesure
– $R(n)$ la covariance du bruit de la $n^{ième}$ mesure
– $E(X)$ l'espérance mathématique de la variable X
– $K(n)$ le gain du filtre associé aux n mesures connues,
le filtre de la figure 1 est représentable par une suite d'équations décrivant le filtre suivant trois phases qui sont une phase d'initialisation à l'instant k=0, une phase de propagation entre un instant k et un instant k+1 et une phase d'intégration de la $n^{ième}$ mesure à l'instant k+1.

Durant la phase d'initialisation la valeur du vecteur d'état $X<0,0>$ du filtre, lorsque l'estimateur n'a pas encore eu connaissance d'une mesure, est égale à l'espérance mathématique $E(X_o)$ de la variable représentée par le vecteur d'état.

De la même façon, la matrice de covariance de l'erreur propre désignée par $P<k/o>$ à l'instant k=0, lorsqu'aucune mesure n'a été effectuée, est égale à la covariance du vecteur d'état.

Enfin comme le montre la figure 1 durant la phase de propagation les relations suivantes sont vérifiées.

$$X<k + 1/n> = F<k>*x<k/n> \quad (1)$$

$$P_{k+1/n} = (F_{k} \cdot P_{k/n} \cdot \text{trans}(F_{k})) + Q_{k} \quad (2)$$

et durant la phase d'intégration des mesures à chaque instant k+1 les relations suivantes sont vérifiées

$$K_{n+1} = P_{k+1/n} \cdot \text{trans}(H_{n+1})$$
$$\cdot \text{inv}((H_{n+1} \cdot P_{k+1/n}$$
$$\cdot \text{trans}(H_{n+1}) + R_{n+1}) \quad (3)$$

où "inv" désigne une opération d'inversion de matrice et "trans" désigne une opération de transposition de matrice.

$$X_{k+1/n+1} = X_{k+1/n} + K_{k+1} \cdot (Z_{n+1}$$
$$- H_{n+1} \cdot X_{k+1/n}) \quad (4)$$

et

$$P_{k+1/n+1} = (I - K_{n+1} \cdot H_{n+1}) \cdot P_{k+1/n} \quad (5)$$

où I est la matrice unité.

La relation (1) définit la propagation où la transition d'état. Elle représente l'évolution du modèle lorsqu'il est livré à lui-même. La relation (2) représente l'évolution prédite par le modèle du terme de covariance de l'erreur d'état due seulement à la propagation. En effet la relation (2) montre que la matrice de transition $F_{k}$ propage l'erreur propre $P_{k/n}$ tout comme elle propage $X_{k/n}$ dans la relation (1) et que l'erreur $Q_{k}$ qui représente l'erreur de modélisation est prise en compte directement. La relation (3) représente l'évolution du gain du filtre et montre que ce gain tient compte de la covariance de l'état propagé ainsi que de l'erreur de mesure $R_{n+1}$. Naturellement la récursivité du filtre repose entièrement sur le calcul de gain défini par la relation (3) qui montre l'influence sur le futur de l'historique du filtre et qui remplace l'accumulation des mesures d'un filtrage au moindre carré récursif.

La relation (4) permet d'obtenir la meilleure estimation au sens des moindres carrés de l'état $X_{k+1/n+1}$ en tenant compte des dernières mesures incidentes $Z_{n+1}$. Dans cette relation l'état X diffère de l'état propagé par le modèle d'une valeur égale au produit par le gain du filtre du résidu Z-H*X. Dans ces conditions le gain du filtre représente bien le poids respectif ou la confiance qui peut être accordée par le filtre aux corrections liées aux nouvelles mesures par rapport à l'état propagé du modèle qui n'est pas une fonction du temps, mais seulement du nombre de mesures. Enfin la relation (5) permet d'obtenir la covariance de l'erreur de l'état calculée en exécution de la relation (4).

Comme montré à la figure 1 l'espace du filtre peut être partagé en un espace des mesures et en un espace des états, l'opérateur matriciel 5 et le gain K de l'amplificateur 1 étant situés à leur frontière commune. Ceci vient du fait que la matrice d'observation H de l'opérateur 5 permet de passer d'un vecteur d'état, à l'équivalent d'une observation et que le gain de Kalman "K" de l'amplificateur 1 permet de passer d'une observation, en fait d'une résiduelle d'observation, à un vecteur d'état, ces deux matrices pouvant dès lors être considérées comme des matrices de changement de coordonnées. Cette organisation présente l'avantage de rendre homogène les vecteurs de mesure aux vecteurs d'état en permettant des changements de coordonnées en dehors du filtre de Kalman. D'autre part, le fait d'effectuer un seul changement de coordonnées dont l'un est à l'inverse de l'autre, permet de constituer les matrices F et H au moyen d'éléments constants et rend l'étape d'inversion matricielle de l'équation (3) triviale, comparée à d'autres méthodes de calcul d'inversion connues comme celle par exemple de factorisation supérieure diagonale de Choleski-Bierman. De la sorte, la stabilité du filtre peut toujours être assurée malgré les gains apportés par les projections du changement de coordonnées effectuées. Notamment et en particulier la non-observabilité du système, c'est-à-dire dans le cas où la dimension des observations ne permet pas de déduire l'état -du système, ne peut pas entraîner d'indétermination à l'intérieur du filtre. Enfin cette disposition permet également une confrontation aisée, sur un même graphique par exemple, des mesures appliquées à l'entrée du filtre avec les états de sa sortie, ce qui en cela facilite le choix lors des mises au point du coefficient Q de la covariance du bruit.

Dans sa mise en oeuvre, le calculateur de navigation selon l'invention qui est représenté à la figure 2, comporte un module de filtrage primaire 6, un module de filtrage secondaire 7 tous deux interposés entre des senseurs 8 et 9 et une base de filtrage à filtre de Kalman commune 10. Cette architecture a pour avantage de pouvoir être étendue à une association quelconque de k modules de filtrage reliant respectivement k senseurs primaires à la base 10 et n modules de filtrage reliant n senseurs secondaires à la base 10, ces senseurs pouvant revêtir des natures très diverses, allant de simples podomètres à des senseurs beaucoup plus complexes comme les récepteurs de radionavigation GPS par exemple. Elle a aussi pour avantage qu'elle permet d'effectuer les changements de coordonnées décrits précédemment en dehors de la base de filtrage 10 grâce à des opérations de préfiltrage adaptées à chaque type de senseur. La base de filtrage 10 est constituée d'un propagateur d'état 11 résolvant les équations (1) et (2) et d'un moniteur d'intégration des mesures 12 recevant des modules 6 et 7 le résultat des équations (3), (4) et (5) précédemment décrites, par chacun des senseurs considérés.

Un module de filtrage primaire 6 se compose d'un préfiltre 13 et d'un intégrateur de mesure 14.

Un module de préfiltrage secondaire 7 se compose d'un préfiltre 15 et d'un estimateur de dérive 16 couplés tous deux l'un à l'autre à un propagateur d'état 17.

Par ailleurs dans ce qui suit il est supposé que chaque senseur délivre une mesure à l'instant k de sorte qu'il n'y a plus de différence à faire entre k et n. Les modules de filtrage primaire 6 et secondaire 7 ont pour rôle de délivrer à la base de filtrage 10 des vecteurs de mesures préfiltrés dont le format est identique aux vecteurs d'état. Cependant les modules de filtrage secondaire 7 sont principalement adaptés pour fonctionner avec des senseurs économiques de bas de gamme, tels que des podomètres ou des compas magnétiques par exemple, alors que les modules de filtrage primaire 6 sont quant à eux adaptés à des senseurs primaires plus sophistiqués tels que des récepteurs de satellites type GPS code CA par exemple. Dans ce dernier cas les paramètres du vecteur d'état appliqués à la base de filtrage 10 sont de façon générale, les trois composantes x, y et z des déplacements du mobile porteur du calculateur entre deux tops "UTC" d'unité de temps universel, les trois paramètres dx, dy, dz des variations des positions x et y et z en mètre par seconde, la dérive $\phi$ du nombre d'éléments de code transmis entre le top UTC et la seconde ronde du temps du récepteur GPS et d $\phi$ la fréquence doppler de l'oscillateur local du récepteur GPS exprimé en mètres par seconde. Dans cet exemple, le choix du vecteur d'état correspond à une dynamique de mobile faible ayant le long d'une trajectoire rectiligne un traînage constant sur lorsqu'une rampe de vitesse lui est appliquée. La position du mobile en latitude, longitude et altitude s'obtient par un calcul externe au filtre, consistant à intégrer les composantes x, y et z. Dans ce cas le propagateur est entièrement déterminé par la matrice de transitions F<k> et par le bruit de processus Q<k>. L'équation matricielle de propagation correspondant du filtre est alors la suivante :

$$
\begin{vmatrix} x \\ y \\ z \\ dx \\ dy \\ dz \\ \psi \\ d\psi \end{vmatrix} <k+1> = \begin{vmatrix} 1 & 0 & 0 & 1 & 0 & 0 & 0 & 0 \\ 0 & 1 & 0 & 0 & 1 & 0 & 0 & 0 \\ 0 & 0 & 1 & 0 & 0 & 1 & 0 & 0 \\ 0 & 0 & 0 & 1 & 0 & 0 & 0 & 0 \\ 0 & 0 & 0 & 0 & 1 & 0 & 0 & 0 \\ 0 & 0 & 0 & 0 & 0 & 1 & 0 & 0 \\ 0 & 0 & 0 & 0 & 0 & 0 & 1 & 1 \\ 0 & 0 & 0 & 0 & 0 & 0 & 0 & 1 \end{vmatrix} * \begin{vmatrix} x \\ y \\ z \\ dx \\ dy \\ dz \\ \psi \\ d\psi \end{vmatrix} <k>
$$

Le bruit de processus Q<k> doit être choisi pour représenter les performances du mobile dans la limite de la dynamique d'accélération qui lui est fixée. Le filtrage primaire qui est effectué par le module de filtre primaire 6 se décompose en une phase de préfiltrage effectuée par le préfiltre 13 qui normalise les coordonnées des mesures dans le format choisi pour le vecteur d'état, en une phase de calcul de dérive d'horloge non représentée et en une phase d'intégration des mesures effectuées 14.

Lorsque par exemple les mesures sont fournies par un récepteur GPS, celles - ci parviennent généralement sous la forme de mesures brutes de pseudo-distances et de delta pseudo-distances le long de l'axe d'observation de quatre satellites observés. Le préfiltrage permet dans ce cas de passer de l'espace des observations brutes à l'espace d'état correspondant pour un satellite s observé, à une équation donnant un vecteur de mesure préfiltré ZP(s)<k> en fonction d'une mesure de pseudo-distance pr(s)<k>.

Si X, Y, Z et $\varnothing$ désignent les variables d'observation homogènes aux variables x, y, z et $\phi$ du vecteur d'état, le vecteur de mesure ZP(s)<k> peut alors être représenté sous la forme vectorielle suivante :

$$Zp(s)<k> = \begin{vmatrix} X \\ Y \\ Z \\ 0 \\ 0 \\ 0 \\ \varnothing \\ 0 \end{vmatrix} <k>$$

L'erreur résiduelle de mesure rpr(s)<k> sur le positionnement du satellite S est dans ce cas égale à la pseudo-distance mesurée pr(s)<k> à laquelle il faut retrancher la position du satellite et ajouter la position du mobile. Cette erreur est décomposable en deux termes représentant l'un, une erreur géométrique sur le positionnement du satellite sur l'axe d'observation et l'autre, une erreur temporelle qui est l'erreur sur le biais d'horloge estimé par le filtre.

Le terme $\phi$ du vecteur d'état représente pour tous les satellites la partie de la résiduelle de mesure due au doppler de l'horloge locale tel qu'il est estimé par le filtre. Cette grandeur est propagée par la base de filtrage et croît linéairement avec le temps. Le terme d $\phi$ du vecteur d'état représente le meilleur estimé du doppler de l'horloge locale exprimé en m/s, son biais étant à peu près constant.

L'erreur géométrique est représentable par des relations de la forme

$$X<k> = \alpha * (rpr(s)<k>-\phi<k>)$$
$$Y<k> = \beta * (rpr(s)<k>-\phi<k>)$$
$$Z<k> = \Gamma * (rpr(s)<k>-\phi<k>)$$

où $\alpha$, $\beta$ et $\Gamma$ sont les cosinus directeurs de l'axe d'observation du satellite s.

Pour l'erreur temporelle, l'erreur de prédiction de résiduelle par $\phi$ est interprétée comme une erreur absolue sur telle que

$$\varnothing<k> = rpr(s)<k>$$

Les équations précédentes définissent totalement un vecteur de mesure préfiltré ZZ(s)<k> dont la matrice d'observation H(s) qui y attachée peut être définie comme suit :

$$H(s)<k> = \begin{vmatrix} 1 & 0 & 0 & 0 & 0 & 0 & 0 & 0 \\ 0 & 1 & 0 & 0 & 0 & 0 & 0 & 0 \\ 0 & 0 & 1 & 0 & 0 & 0 & 0 & 0 \\ 0 & 0 & 0 & 0 & 0 & 0 & 0 & 0 \\ 0 & 0 & 0 & 0 & 0 & 0 & 0 & 0 \\ 0 & 0 & 0 & 0 & 0 & 0 & 0 & 0 \\ 0 & 0 & 0 & 0 & 0 & 0 & 1 & 0 \\ 0 & 0 & 0 & 0 & 0 & 0 & 0 & 0 \end{vmatrix}$$

De façon similaire au calcul de l'erreur résiduelle de mesure sur la position, l'erreur résiduelle d'observation de delta pseudo-distance, désignée ci-après par rdr(s)<k>, est égale à la valeur de la delta pseudo-distance mesurée à laquelle il faut retrancher la vitesse du satellite sur l'axe d'observation et ajouter la vitesse du porteur sur l'axe d'observation du satellite.

Le filtrage permettant de passer de l'espace des observations brutes à l'espace d'état correspond dans ce cas pour un satellite, à l'équation donnant un vecteur de mesure préfiltré ZD(s)<k> en fonction de la mesure d'une delta pseudo-distance dr(s). Comme précédemment ZD(s)<k> est homogène à X et est représentable par une relation matricielle de la forme :

$$ZD(s)<k> = \begin{vmatrix} 0 \\ 0 \\ 0 \\ dX \\ dY \\ dZ \\ 0 \\ d\varnothing \end{vmatrix} <k>$$

dans laquelle dX, dY, dZ et d∅ sont les variables d'observation homogènes aux variables dx, dy, dz et dφ du vecteur d'état.

Comme précédemment une résiduelle de mesure rdr(s)<k> représente une erreur mesurée de vitesse du satellite décomposable en deux termes représentant l'un une erreur géométrique qui est l'erreur de vitesse du satellite sur l'axe d'observation et l'autre une erreur temporelle qui est l'erreur sur le doppler de l'horloge estimée par le filtre.

Pour l'erreur géométrique les quantités dX<k>, dY<k> et dZ<k> vérifient les relations suivantes :

$$dX<k> = \alpha * (rdr(s)<k>-d\phi<k>)$$
$$dY<k> = \beta * (rdr(s)<k>-d\phi<k>)$$
$$dZ<k> = \Gamma * (rdr(s)<k>-d\phi<k>)$$

où $\alpha$, $\beta$ et $\Gamma$ sont les cosinus directeurs de l'axe d'observation du satellite s.

Pour l'erreur temporelle, l'erreur de prédiction de résiduelle par φ est interprétée comme un incrément de doppler de l'horloge locale :

$$d\varnothing<k> = (rdr(s)<k>-\phi<k>)-d\phi<k>$$

Ces quatre équations définissent totalement le vecteur de mesure préfiltré ZD(s)<k>, la matrice d'observation H(s)<k> attachée à ce vecteur étant définie comme suit :

$$H(s)<k> = \begin{vmatrix} 0 & 0 & 0 & 0 & 0 & 0 & 0 & 0 \\ 0 & 0 & 0 & 0 & 0 & 0 & 0 & 0 \\ 0 & 0 & 0 & 0 & 0 & 0 & 0 & 0 \\ 0 & 0 & 0 & 1 & 0 & 0 & 0 & 0 \\ 0 & 0 & 0 & 0 & 1 & 0 & 0 & 0 \\ 0 & 0 & 0 & 0 & 0 & 1 & 0 & 0 \\ 0 & 0 & 0 & 0 & 0 & 0 & 0 & 0 \\ 0 & 0 & 0 & 0 & 0 & 0 & 0 & 1 \end{vmatrix}$$

Les calculs qui viennent d'être décrits sont répétés N fois pour les N satellites observés.

Les filtres secondaires 7 sont principalement chargés de secourir un filtre primaire dans le cas où il y aurait une défaillance de fonctionnement, soit parce que le senseur primaire voit sa précision se dégrader, soit parce que le senseur primaire ne peut plus fonctionner (cas d'un brouillage ou d'un masque en GPS). Dans ces conditions chaque filtre secondaire a la possibilité de fonctionner selon deux modes différents, d'étalonnage et de secours.

Dans le mode d'étalonnage, lorsque le filtre primaire est opérationnel, le préfiltrage secondaire alimente un filtre de Kalman secondaire dont l'état représente le meilleur estimé de la dérive du senseur secondaire par rapport à l'état du filtre de Kalman primaire. Dans le mode secours, le filtre de Kalman secondaire est débranché et le senseur primaire est également déconnecté. Dans ce cas le résultat du préfiltrage secondaire corrigé par le dernier état du filtre de Kalman secondaire est injecté comme mesure à la place des mesures du senseur primaire. Le passage en mode secours est évidemment conditionné par la surveillance du module de l'erreur propre P<k+1/k+1> dans le filtre de Kalman primaire, ou par la non existence de mesures de pseudo-distances et de delta pseudo-distances pendant un certain temps.

Contrairement à ce qui se passe pour un préfiltrage primaire, le préfiltrage secondaire effectue une compensation des non linéarités du senseur secondaire. A titre d'exemple, si C désigne le cap du mobile mesuré par un senseur, le préfiltrage a alors pour résultat un vecteur d'observation noté ZC<k>, qui pourra être appliqué au filtre de Kalman primaire seulement en mode secours, avec la matrice d'observation correspondante.

Pour cela, il faut naturellement tenir compte des causes possibles d'erreur de cap qui sont classiquement dues soit :

– à un biais b<k> de cap lentement variable dû à la déclinaison magnétique locale et à l'influence des grosses masses magnétiques avoisinantes,

– à une non linéarité due à la courbure des lignes de champ par le châssis métallique du véhicule. En supposant connu (parce que mesurée) cette non linéarité, et qu'elle figure dans un tableau NL(C), le préfiltrage pourra alors mettre à jour ce tableau en générant 4 estimées de non linéarités applicables aux 4 composantes du vecteur de mesure préfiltré,

– ou à un bruit de mesure correspondant à des chocs, vibrations, perturbations électromagnétiques, etc. auxquels est soumis le senseur, ce bruit pouvant alors être estimé par une matrice R attachée au senseur.

En prenant comme variables auxiliaires $\Gamma$ et $\eta$ tels que

$$\Gamma^2 = x^2<k> + y^2<k> + z^2<k>$$

7

$$\eta^2 = dx^2{<}k{>} + dy^2{<}k{>} + dz^2{<}k{>}$$

le préfiltrage obtenu dans ces conditions est alors représentable par la relation matricielle suivante :

$$
ZC{<}k{>} = \begin{vmatrix} Z \\ Y \\ Z \\ dX \\ dY \\ dZ \\ \varphi \\ d\varphi \end{vmatrix} {<}k{>} = \begin{vmatrix} \Gamma\sin\ (C{+}NL1(C)\ +\ b{<}k{>} \\ \Gamma\cos\ (C{+}NL2(C)\ +\ b{<}k{>} \\ 0 \\ \eta\sin\ (C{+}NL3(C)\ +\ b{<}k{>}) \\ \eta\cos\ (C{+}NL4(C)\ +\ b{<}k{>} \\ 0 \\ 0 \\ 0 \end{vmatrix}
$$

La variable b<k> est obtenue en cours d'étalonnage en résolvant l'équation :

$$ZC{<}k{>} = X{<}k{>}$$

Cette résolution peut être effectuée en 3 temps. En faisant au début du calcul NL = NL1 = NL2 = NL3 = NL4, 4 valeurs différentes, b1, b2, b3 et b4 de l'inconnue b<k> peuvent être obtenues, d'où il peut être extrait une moyenne b<k> de ces 4 valeurs. Ensuite un calcul des non-linéarités peut avoir lieu par les relations

$$NL1(C) = NL + (b1{<}k{>}{-}b{<}k{>})$$
$$NL2(C) = NL + (b2{<}k{>}{-}b{<}k{>})$$
$$NL3(C) = NL + (b3{<}k{>}{-}b{<}k{>})$$
$$NL4(C) = NL + (b4{<}k{>}{-}b{<}k{>})$$

Les résultats obtenus sont alors conservés et forment les résiduelles des non linéarités estimées par le préfiltrage. Le calcul lui même peut se faire par inversion directe, ou par linéarisation au voisinage du cap C de la matrice inverse ou éventuellement par approximations successives.

Dans le mode secours, b<k> et NL1, NL2, NL3 et NL4 sont gelés et ZC<k> est injecté comme mesure dans le filtre de Kalman primaire. La valeur moyenne de b<k> est alors calculée par l'estimateur de dérives secondaires.

La matrice d'observation H<k> associée à ZC<k> a alors la forme suivante :

$$
H{<}k{>} = \begin{vmatrix} 1 & 0 & 0 & 0 & 0 & 0 & 0 & 0 \\ 0 & 1 & 0 & 0 & 0 & 0 & 0 & 0 \\ 0 & 0 & 0 & 0 & 0 & 0 & 0 & 0 \\ 0 & 0 & 0 & 1 & 0 & 0 & 0 & 0 \\ 0 & 0 & 0 & 0 & 1 & 0 & 0 & 0 \\ 0 & 0 & 0 & 0 & 0 & 0 & 0 & 0 \\ 0 & 0 & 0 & 0 & 0 & 0 & 0 & 0 \\ 0 & 0 & 0 & 0 & 0 & 0 & 0 & 0 \end{vmatrix}
$$

et le bruit d'observation est choisi pour refléter les caractéristiques du senseur.

L'estimateur correspondant est un filtre de Kalman qui calcule la moyenne de tous les b<k> du préfiltrage précédent. En prenant par exemple comine vecteur d'état

$$
X{<}k{>} = \begin{vmatrix} b{<}k{>} \\ db{<}k{>} \end{vmatrix}
$$

avec

$$db{<}k{>} = b{<}k{>} - b{<}k{-}1{>}$$

les matrices F<k> et H<k> s'écrivent alors

$$F{<}k{>} \;=\; \begin{vmatrix} 1 & 1 \\ 0 & 1 \end{vmatrix} \qquad \text{et} \qquad H{<}k{>} \;=\; \begin{vmatrix} 1 \\ 0 \end{vmatrix}$$

## Revendications

1.  Calculateur de navigation multisenseurs à filtre de Kalman modulaire embarqué sur un mobile comportant un nombre déterminé de modules de filtrage primaires (6) et secondaires (7) interposés respectivement entre des senseurs (8, 9) et une base de filtrage de Kalman commune (10), caractérisé en ce que la base de filtrage de Kalman commune (10) comporte un propagateur d'état (11) couplé à un moniteur d'intégration des mesures (12) et en ce que les modules de filtrage primaire (6) et secondaire (7) appliquent des vecteurs de mesures préfiltrés à la base de filtrage (10) dans un format identique au vecteur d'état de la base de filtrage.

2.  Calculateur selon la revendication 1 caractérisé en ce qu'au moins un module de filtrage primaire est couplé à un récepteur de navigation par satellite type GPS code C/A.

3.  Calculateur selon les revendications 1 et 2 caractérisé en ce que les modules de filtrage secondaires reçoivent des valeurs de cap et de distance mesurées respectivement par des compas de navigation et des podomètres.

4.  Calculateur selon l'une quelconque des revendications 2 et 3 caractérisé en ce que le module de filtrage primaire applique à la base de filtrage (10) un vecteur d'état composé de trois composantes x, y et z des déplacements du mobile relativement au géoïde terrestre des composantes dx, dy, dz des variations des positions du mobile, un paramètre de dérive $\phi$ du nombre d'éléments de code transmis par le satellite ainsi que la fréquence doppler d $\phi$ de l'oscillateur local du récepteur GPS.

5.  Calculateur selon l'une quelconque des revendications 2 et 4 caractérisé en ce que chaque module de filtrage secondaire est composé par un filtre de Kalman simplifié comportant un préfiltre secondaire (15) et un estimateur de dérive (16) couplés tous deux à un propagateur d'état (17).

6.  Calculateur selon la revendication 5 caractérisé en ce que chaque préfiltre secondaire (15) compense les non linéarités d'un senseur secondaire.

7.  Calculateur selon la revendication 6 caractérisé en ce que le résultat d'un préfiltrage secondaire est utilisé par la base de filtrage de Kalman primaire (10) en mode secours.

8.  Calculateur selon l'un quelconque des revendications 5 à 7 caractérisé en ce que l'estimateur de dérive (16) est un filtre de Kalman effectuant le calcul de l'estimé du biais du mobile fourni par le senseur secondaire correspondant.

EP 0 504 024 A1

FIG.1

FIG.2

**Office européen des brevets**

# RAPPORT DE RECHERCHE EUROPEENNE

Numero de la demande

EP 92 40 0590

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | IEEE 1987 NATIONAL AEROSPACE AND ELECTRONICS CONFERENCE NAECON 1987; MAY 18-22, 1987; N.A. CARLSON:FEDERATED SQUARE ROOT FILTER FOR DECENTRALIZED PARALLEL PROCESSES; P 1448-1456 <br> * page 1449, colonne 1, ligne 49 - page 1450, colonne 1, ligne 18 * <br> --- | 1 | H03H17/02 <br> G01S5/14 |
| A | WO-A-8 801 409 (GRUMMAN AEROSPACE CORP.) 25 Février 1988 <br> * page 7, ligne 1 - page 10, ligne 25; figures 2,3 * <br> --- | 2 | |
| A | US-A-4 876 659 (W.S. DEVEREUX ET AL) 24 Octobre 1989 <br> * le document en entier * <br> --- | 2 | |
| A | IEEE EASCON 1985; 18 th ANNUAL ELECTRONICS AND AEROSPACE SYSTEMS CONFERENCE; 28-30 /10/ 1985 WASHINGTON (US) ; GPS GEODESY EXPERIMENTAL RESULTS USING THE KALMAN FILTER APPROACH: P9-18 P. 9-10 INTRODUCTION <br> * figure 2 * <br> ----- | 5 | |

**DOMAINES TECHNIQUES RECHERCHES (Int. Cl.5)**

H03H
G01S

Le présent rapport a été établi pour toutes les revendications

| Lieu de la recherche | Date d'achèvement de la recherche | Examinateur |
|---|---|---|
| LA HAYE | 26 JUIN 1992 | COPPIETERS C. |